**Europäisches Patentamt**

**European Patent Office**

**Office européen des brevets**

(19)

(11) Veröffentlichungsnummer: **0 078 336**

**B1**

(12) # EUROPÄISCHE PATENTSCHRIFT

(45) Veröffentlichungstag der Patentschrift:
**03.02.88**

(21) Anmeldenummer: **81109370.7**

(22) Anmeldetag: **30.10.81**

(51) Int. Cl.⁴: **H 01 L 21/308 //**
**G03F9/00, G03F7/26**

(54) Schattenwurfmaske für die Ionenimplantation und die Ionenstrahllithographie.

(43) Veröffentlichungstag der Anmeldung:
**11.05.83 Patentblatt 83/19**

(45) Bekanntmachung des Hinweises auf die Patenterteilung:
**03.02.88 Patentblatt 88/5**

(84) Benannte Vertragsstaaten:
**DE FR GB IT**

(56) Entgegenhaltungen:
**EP-A-0 001 038**
**DE-A-2 922 416**

(73) Patentinhaber: **IBM DEUTSCHLAND GMBH,**
**Pascalstrasse 100, D-7000 Stuttgart 80 (DE)**
(84) Benannte Vertragsstaaten: **DE**

(73) Patentinhaber: **International Business Machines**
**Corporation, Old Orchard Road, Armonk, N.Y.**
**10504 (US)**
(84) Benannte Vertragsstaaten: **FR GB IT**

(72) Erfinder: **Bohlen, Harald, Geleener Strasse 26,**
**D-7030 Böblingen (DE)**
Erfinder: **Greschner, Johann, Dr., Zollernstrasse**
**14, D-7401 Pliezhausen 2 (DE)**
Erfinder: **Nehmiz, Peter, Dr., Karl- Weller- Strasse**
**2, D-7000 Stuttgart 80 (DE)**

(74) Vertreter: **Oechssler, Dietrich, Dr. rer. nat., IBM**
**Deutschland GmbH Patentwesen und**
**Urheberrecht Schönaicher Strasse 220, D-7030**
**Böblingen (DE)**

## Beschreibung

Die Erfindung betrifft eine Schattenwurfmaske, welche eine dünne P-dotierte Siliciumschicht mit durchgehenden, dem Maskenmuster angepaßten Löchern und eine diese Schicht in Bereichen, wo sich keine Löcher befinden, unterstützendes Gitter aus anders als die Siliciumschicht dotierten Siliciumrippen enthält, welche mindestens auf ihrer von dem Gitter (2) abgewandten Seite (im folgenden Oberseite genannt) eine Ionen absorbierende Schicht aufweist und bei welcher mindestens die der Ionenstrahlung ausgesetzte Oberfläche elektrisch und thermisch leitfähig ist.

Die Ionenimplantation ist ein bekanntes Verfahren, welches in großem Umfang zum Dotieren von Halbleitermaterial verwendet wird. Um ein Halbleitersubstrat, beispielsweise ein Siliciumplättchen, selektiv zu dotieren wird heute in den meisten Fällen auf der Halbleiteroberfläche eine Maske erzeugt, indem auf der Oberfläche eine Schicht aus einem Material, wie z. B. einem Photolack oder einem dielektrischen Material, aufgebracht und anschließend ein Muster mit durchgehenden Löchern, welches die zu dotierenden Halbleiterbereiche unbedeckt läßt, in der Schicht erzeugt wird. Derartige Masken haben den Nachteil, daß sie nur für einen Implantationsprozeß verwendet werden können und außerdem häufig anschließend entfernt werden müssen. Bei einem anderen Ionenimplantationsverfahren, welches ohne solche Masken auskommt, läßt man einen Ionenstrahl, dessen Durchmesser kleiner ist als die Abmessung des kleinsten herzustellenden dotierten Bereichs, in der Weise den Halbleiterkörper überstreichen, daß am Ende der Bestrahlung sich jeder Punkt der Halbleiteroberfläche im Strahlengang befunden hat, wobei beim Überstreichen der Ionenstrahl überall dort computergesteuert ausgeblendet wird, wo das Halbleitermaterial nicht bestrahlt werden soll. Mit diesem Verfahren lassen sich sehr komplexe und kleinste Strukturelemente aufweisende dotierte Halbleiterstrukturen mit ausreichender Genauigkeit erzeugen. Nachteilig an diesem Verfahren ist jedoch, daß es apparativ sehr aufwendig ist und daß der erreichbare Durchsatz nur dann für eine fabrikmäßige Fertigung ausreicht, wenn mit einem sehr hohen Ionenstrom gearbeitet wird. In der EP-A-00 01 038 wird eine aus Silicium bestehende Maske beschrieben, welche auch zur Verwendung bei der Ionenimplantation geeignet ist. Diese Maske ist selbstunterstützend und besteht aus einer dünnen, durchgehende Maskenöffnungen aufweisenden Siliciumschicht und einem ebenfalls aus Silicium bestehenden, jedoch niedriger als die Siliciumschicht dotierten Gerüst, welche die Siliciumschicht in den Bereichen, in denen sich keine Maskenöffnungen befindet, stützt. Diese Maske wird vor der Ionenimplantation auf das zu dotierende Halbleitersubstrat bzw. auf einen auf dem

Halbleitersubstrat liegenden, $\leqslant$ 20 μm dicken Distanzring gelegt und nach der Ionenimplantation wieder abgenommen. Die Maske ist also mehrfach verwendbar. Es hat sich jedoch gezeigt, daß, wenn die Maske sehr oft wiederverwendet wird, die dünne Siliciumschicht ihre mechanische Stabilität zum Teil verliert und als Folge davon die Siliciummaske ihre Gestalt irreversibel verändert, was, wenn mit der Maske sehr kleine und dicht gepackte dotierte Bereiche erzeugt werden sollen, nicht tolerierbar ist.

Mit der zunehmenden Mikrominiaturisierung in der Halbleitertechnik, welche zur Folge hat, daß die lithographisch zu übertragenden Musterelemente immer kleiner werden, stößt auch bald die Elektronenstrahllithographie an die Grenzen ihrer technischen Möglichkeiten. Dadurch wird die Lithographie mit Ionenstrahlen, welche gegenüber den Elektronenstrahlen einige beachtliche Vorteile hat, immer interessanter. Beispielsweise tritt bei Ionenstrahlen - anders als bei Elektronenstrahlen - nur ein vernachlässigbar geringer Proximity-Effekt auf. Eine gute Zusammenfassung der Vorteile von Ionenstrahlen gegenüber den Elektronenstrahlen befindet sich in dem Artikel von R. L. Seliger und P. A. Sullivan mit dem Titel "Ion beams promise practical systems for submicrometer wafer lithography", welcher in Electronics vom 27. März 1980 auf Seite 142 ff. veröffentlicht ist. Aus dem genannten Artikel ergibt sich auch, daß bei der Ionenlithographie - ebenso wie bei der Ionenimplantation - die Selektivität der Anwendung entweder durch einen ablenkbaren fokussierten Strahl oder durch die Verwendung von Masken erreicht werden kann. Die von den Autoren beschriebenen Masken bestehen aus einem Ionen absorbierenden Material, welches auf einem unterstützenden Film aus einkristallinem Silicium oder aus Aluminiumoxid aufliegt. Die zum Bestrahlen verwendeten Ionen müssen also bei diesen Masken, bevor sie auf das zu bestrahlende Substrat gelangen, ein Material durchdringen. In der DE-A-29 22 416 sind Masken beschrieben, welche bevorzugt bei der Elektronenstrahllithographie aber auch bei der Ionenstrahllithographie einsetzbar sind. Die in der Offenlegungsschrift beschriebenen Masken weisen an den nicht vom Maskenmaterial bedeckten Bereichen durchgehende Löcher in dem unterstützenden, aus einkristallinem P+-dotiertem Silicium bestehenden, freitragenden Film auf. Durchgehende Löcher in der unterstützenden Schicht sind vorteilhaft, weil Ionen, welche eine Materialschicht - und sei sie auch noch so dünn - durchdringen müssen, notwendigerweise gestreut werden. Zwar ist die Streuung erheblich geringer als bei der Verwendung von Elektronen. Um aber Strukturen von $\leqslant$ 0,5 μm zu übertragen, ist auch die Verwendung einer sogenannten "Channeling-Schicht" nicht mehr tolerierbar. Eine "Channeling-Schicht" ist eine Einkristallmembran, durch welche die Ionen bei optimal gewähltem Einschußwinkel mit einer nur minimalen Streuung hindurchkommen.

Ursprünglich war man davon ausgegangen, daß für die Ionenstrahl- und die Elektronenstrahllithographie grundsätzlich dieselben Masken verwendet werden können. Wie jedoch O. Behringer und R. Speidel auf dem Kongreß "Microcircuit Engineering 81", welcher vom 28. bis 30. September 1981 in Lausanne stattfand, in einem Vortrag mit dem Titel "Investigation of the radiation loads of a selfsupporting silicon mask in an ion beam proximity printer" dargelegt haben, kann die Bestrahlung mit Ionen zu einer reversiblen oder irreversiblen Veränderung der Maske führen. Behringer und Speidel haben bei ihren Versuchen drei Typen von Masken verwendet, welche alle ein Grundgerüst aus einem durchgehende Löcher aufweisenden, aus P+-dotiertem einkristallinen Silicium bestehenden und durch ein Gitter von Siliciumrippen gestützten Film hatten. Die Masken des ersten Typs waren beidseitig mit Gold, die Masken des zweiten Typs waren beidseitig mit Aluminium beschichtet und die Masken des dritten Typs bestanden nur aus dem Siliciumgerüst. Bei den Masken des ersten Typs konnten die Autoren keine beachtlichen Veränderungen (>0,2 µm) feststellen. Die Masken des zweiten Typs wurden durch den Ionenbeschuß mit der Zeit uneben. Die Unebenheit konnte jedoch durch ein 15 Minuten dauerndes Tempern bei 400°C wieder beseitigt werden. Die Masken des dritten Typs wurden bereits nach einer relativ kurzen Benutzungsdauer zerstört, was die Autoren auf die schlechte thermische Leitfähigkeit der Maske zurückführen. Die Ergebnisse der Autoren weisen zwar darauf hin, daß die Masken des ersten Typs für die Ionenstrahllithographie geeignet sind, jedoch haben die Erfinder des Gegenstandes der vorliegenden Anmeldung festgestellt, daß bei der Verwendung von goldbeschichteten Ionenstrahlmasken eine Kontamination der bestrahlten Substrate mit Gold eintritt, welche - insbesondere wegen der ausgeprägten Effekte, welche Gold in Halbleitermaterial hervorruft - nicht toleriert werden kann.

Es ist deshalb die Aufgabe der Erfindung, eine Schattenwurfmaske für die Ionenimplantation und die Ionenstrahllithographie anzugeben, welche im Gebrauch dimensionsstabil ist, keine beachtliche Kontamination der bestrahlten Substrate hervorruft und reproduzierbar unter fabrikmäßigen Bedingungen herstellbar ist.

Diese Aufgabe wird mit Masken der eingangs genannten Art mit den Merkmalen der kennzeichnenden Teile der Ansprüche 1 und 6 gelöst.

Es hat sich gezeigt, daß es schwierig ist, die Merkmale der erfindungsgemäßen Maske gemäss den Anspruch 1 gleichzeitig zu verwirklichen. Als versucht wurde, auf der der Ionenstrahlung ausgesetzten Seite der Maske statt eines Materials, welches - wie Gold - eine gute Absorptionsfähigkeit zeigt, jedoch nicht ausreichend ionenbeständig ist, ein Material zu verwenden, das sowohl Ionen zu absorbieren vermag als auch mechanisch widerstandsfähig ist - als ein solches Material wurde u.a. Tantal ermittelt -, wurde eine untolerierbare Deformierung der Maske festgestellt, welche auf mechanische Spannungen zurückzuführen ist, welche beim Aufbringen des Tantals entstanden, wobei Eigenspannungen in der Tantalschicht als Ursache anzusehen sind, oder sich bei der Erwärmung der Maske während der Ionenbestrahlung im Tantal aufbauten. Es wurde dann versucht, die mechanischen Spannungen dadurch auf ein erträgliches Maß zu reduzieren, daß die absorbierende und mechanisch widerstandsfähige bzw. ionenbeständige Schicht nur so dick gemacht wurde, daß die Gesamtdicke der Maske ausreichte, um die Ionen vollständig zu absorbieren. Dabei ergab sich jedoch, daß - anders als Behringer und Speidel (s.o.) meinen - es zum Schutz der dünnen P-dotierten Siliciumschicht vor den Wirkungen der Ionenstrahlung zu schützen, nicht ausreicht für eine ausreichende Wärmeableitung zu sorgen, sondern daß die P+-dotierte Siliciumschicht ihre Stabilität verliert, wenn sie der Ionenstrahlung ausgesetzt ist. Daraufhin wurde versucht, durch Verwendung einer aus zwei Schichten bestehenden, der Ionenstrahlung ausgesetzten Bedeckung, wobei auf eine untere, an das Silicium grenzende Schicht aus einem absorptionsfähigen, jedoch mechanisch nicht sehr widerstandsfähigen und nicht zum Aufbau von mechanischen Spannungen neigenden Material, wie z. B. Gold, eine dünne Schicht aus einem mechanisch widerstandsfähigen und zum Aufbau von mechanischen Spannungen neigenden Material, wie z. B. Molybdän, aufgebracht war, das Auftreten von mechanischen Spannungen zu verhindern aber gleichzeitig zu gewährleisten, daß die Maske ionenbeständig ist und die Ionen nicht in das Silicium eindringen können. Es wurde jedoch gefunden, daß das Problem der mechanischen Spannungen auch bei einer solchen Materialkombination, offenbar wegen des Auftretens eines Bimetalleffekts auftrat.

Aus dieser Schwierigkeit heraus wurde ein Weg gefunden, welcher es erlaubt, die genannten Vorteile, welche bei der Verwendung einer einzigen, sowohl absorbierenden als auch mechanisch widerstandsfähigen Schicht bzw. einer Doppelschicht der genannten Art erzielt werden, auszunutzen, ohne den durch die im Betrieb auftretenden mechanischen Spannungen verursachten Nachteil in Kauf nehmen zu müssen. Die Lösung des Problems besteht darin, daß auf der dem zu bestrahlenden Substrat zugewandten Seite eine Beschichtung aufgebracht wird, welche ihrerseits mechanische Spannungen aufbaut, und daß diese Beschichtung in ihrer Dicke und ihrer Zusammensetzung so auf die Beschichtung, welche sich auf der den Ionenstrahlen ausgesetzten Seite der Maske befindet, abgestimmt ist, daß sich die in den beiden Beschichtungen auftretenden mechanischen Spannungen kompensieren. Eine zusätzliche Funktion dieser Beschichtung auf der dem Substrat zugewandten Seite der Maske kann darin bestehen, die Wegführung der in der Maske erzeugten Wärme noch zu verbessern.

Trotz der unbestreitbaren Vorteile der zusätzlichen Beschichtung auf der Maskenunterseite ist nicht zu verkennen, daß durch sie die Herstellung der Maske aufwendiger wird. Es wurde deshalb auch noch nach einer Lösung gesucht, welche ohne die zusätzliche Beschichtung auskommt. Gefunden wurde schließlich eine Ausführungsform der erfindungsgemäßen Maske, welche im Anspruch 6 definiert ist, und bei welcher auf der der Ionenstrahlung zugewandten Seite des Siliciumgerüsts eine Goldschicht und auf dieser eine dünne Schicht aus Kohlenstoff aufgebracht ist. Kohlenstoff ist gegenüber Ionenstrahlen sehr resistent (Kohlenstoff ist ungefähr 30mal ionenbeständiger als Gold), und es hat sich gezeigt, daß bereits eine relativ dünne Kohlenstoffschicht, durch welche die Ionenstrahlung praktisch ungeschwächt hindurchgeht, eine Abtragung von Gold zuverlässig verhindert wird. Kohlenstoff ist außerdem thermisch und elektrisch leitfähig. Gold ist, wie bereits bekannt, ein sehr guter Ionenabsorber. Zu diesen genannten Vorteilen der Kohlenstoff/Goldbeschichtung kommt noch als weiterer großer Vorteil hinzu, daß in dieser Beschichtung bei der Verwendung der Maske keine mechanischen Spannungen aufgebaut werden. Sowohl Gold - jedenfalls, wenn es dünner als 1 μm ist -, als auch Kohlenstoff neigen für sich allein genommen nicht zum Aufbau von mechanischen Spannungen. Aber während die Kombination aus Gold und beispielsweise Molybdän wegen des oben angesprochenen Bimetalleffekts eine mechanische Spannung aufbaut, ist dies bei der Kombination von Gold mit Kohlenstoff nicht der Fall.

Weitere vorteilhafte Ausgestaltungen der Erfindung ergeben sich aus den Unteransprüchen.

Die Erfindung wird anhand von durch Zeichnungen erläuterten Ausführungsbeispielen beschrieben. Es zeigen:

Fig. 1A - 1E in schematischen Querschnittszeichnungen fünf Ausführungsformen der erfindungsgemäßen Maske und

Fig. 2A - 2H in schematischen Querschnittsdarstellungen die in der Fig. 1C gezeigte Maske in verschiedenen Stadien ihrer Herstellung.

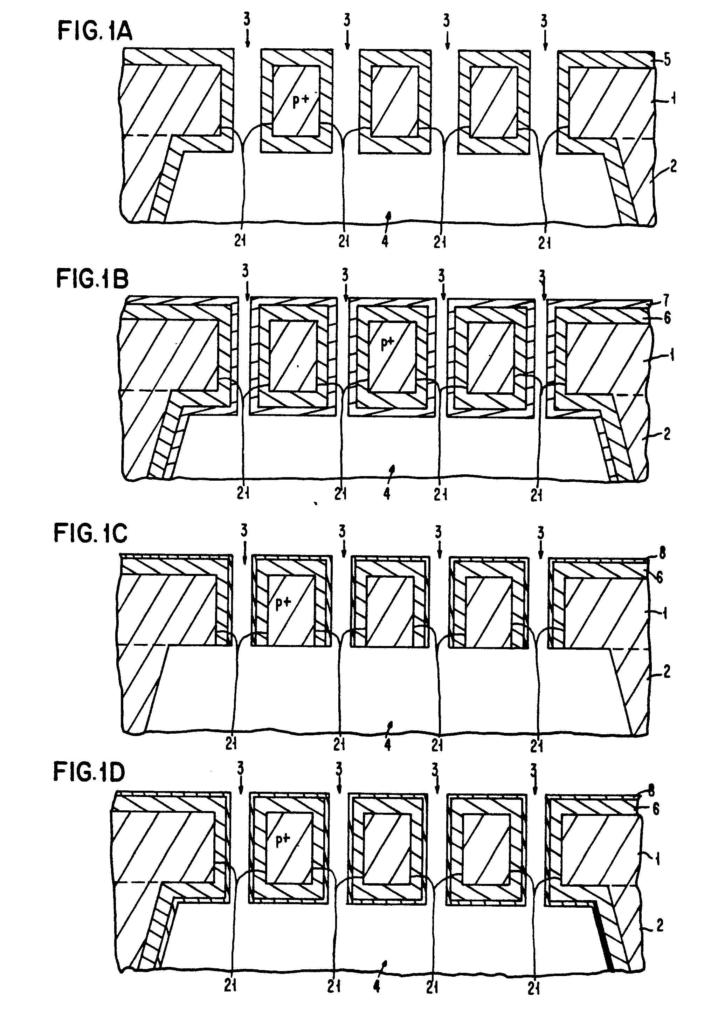

Die Fig. 1 zeigt in einer schematischen Querschnittsdarstellung eine Ausführungsform der erfindungsgemäßen Maske, in welcher das Siliciumgerüst der Maske beidseitig mit einer Schicht aus einem Material bedeckt ist, welches sowohl eine gute Absorptionsfähigkeit als auch gegenüber Ionenstrahlen eine gute mechanische Widerstandsfähigkeit aufweist. Die Fig. 1 zeigt einen Ausschnitt aus einem Siliciumplättchen, welches eine dünne Oberflächenschicht 1 aufweist, welche sich durch ihre P+-Dotierung vom übrigen P- oder N-dotierten Material (Substrat 2) unterscheidet. Durch die Schicht 1 hindurch gehen Löcher bzw. Fenster 3, deren Wände im wesentlichen senkrecht zur Oberfläche der Schicht 1 verlaufen und welche paktisch das Maskenmuster definieren. Wannenförmige Vertiefungen 4 erstrecken sich von der (in der Fig. 1 nicht gezeigten) Oberfläche des Substrats 2, welche nicht an die Schicht 1 grenzen, soweit in das Substrat 2 hinein, daß die Löcher 3 zur Wanne 4 hin geöffnet sind. Ein Siliciumplättchen kann eine größere Anzahl von wannenförmigen Vertiefungen 4 aufweisen, welche durch ein rippenförmiges, aus dem Substrat 2 gebildetes Gitter voneinander getrennt sind. Bevorzugt ist jede einzelne wannenförmige Vertiefung 4 einem in sich abgeschlossenen Maskenausschnitt in der Weise zugeordnet, daß alle diesem Maskenausschnitt zugeordneten Löcher sich in diese wannenförmige Vertiefung 4 hinein öffnen. Ein solcher in sich abgeschlossener Maskenausschnitt ist beispielsweise der einem Chip auf einem Halbleiterplättchen zugeordnete Maskenbereich, weshalb dann in diesem Fall die lateralen Abmessungen der wannenförmigen Vertiefungen 4 auf die Chipgröße abgestimmt sind. Chipgrößen von 6 x 6 mm sind heute bereits üblich. Wenn es sich bei dem in der Maske verwendeten Siliciumsubstrat um ein einkristallines Siliciumplättchen mit einer (100)-Orientierung handelt, weisen die Wände der wannenförmigen Vertiefungen 4 eine Neigung von ca. 54° auf. Ist das Siliciumplättchen ein kommerziell erhältiches, so hat dieses typischerweise eine Dicke von ungefähr 400 μm. Die Dicke des Siliciumsubstrats 2 in der Maskenstruktur kann allerdings geringer sein als die Dicke des Siliciumplättchens, bei dem von seiner Herstellung ausgegangen wird. Dies muß beispielsweise dann der Fall sein, wenn die den einzelnen wannenförmigen Vertiefungen 4 zugeordneten Maskenausschnitte einen Abstand voneinander haben sollen, welcher kürzer ist als die Strecke, zwischen den Wänden zweier benachbarter wannenförmiger Vertiefungen 4 an ihrem tiefsten Punkt, welche sich unter Berücksichtigung des oben erwähnten 54° Winkels und einer Substratdicke von 400 μm ergibt. Die Oberflächenschicht 1 vom P+-Typ, welche bevorzugt mit Bor dotiert ist, hat eine Dicke im Bereich zwischen etwa 1 und etwa 4 μm und bevorzugt zwischen etwa 3 und etwa 4 μm. Die Dotierung der P+-dotierten Schicht fallt senkrecht zur Substratoberfläche mit zunehmender Entfernung von dieser ab, und die Dicke der P+-dotierten Schicht ist definiert als derjenige Abstand von der Substratoberfläche, bei welchem die Dotierung auf einen Wert von ungefähr $7 \times 10^{19}$ Atomen/cm$^3$ abgefallen ist. Die minimale Breite der Löcher 3 liegt unterhalb 1 μm.

Die oben beschriebene Siliciumstruktur stellt das allen Ausführungsformen der erfindungsgemäßen Maske gemeinsame Siliciumgerüst dar. Die Maske, d.h. genauer gesagt die Oberflächenschicht 1, erhält ihre Stabilität im wesentlichen durch ihre P+-Dotierung, durch das als Gitter aus Siliciumrippen ausgebildete Substrat 2 und durch den einkristallinen Charakter des Gerüsts. Dabei ist es die Aufgabe des rippenförmigen Gitters, zwischen den wannenförmigen Vertiefungen 4 insbesondere die Maske gegenüber mechanischen und auch thermischen Belastungen widerstandsfähiger zu machen, so daß sie beispielsweise in einer fabrikmäßigen Fertigung gehandhabt werden kann, ohne daß sie beschädigt wird, wenn sie mit angemessener Sorgfalt behandelt wird. Das rippenförmige Netz kann diese stabilisierende Wirkung aufgrund seiner relativ großen Dicke erbringen. Trotzdem die einzelne Siliciumrippe Platz benötigt, ist der Platzbedarf aller Siliciumrippen, bezogen auf die Gesamtfläche der Maske, relativ gering, und zwar deshalb, weil bei der erfindungsgemäßen Maske die Flächen der Maskenausschnitte zwischen benachbarten Siliciumrippen beachtlich groß sein können. Die Dicke der Siliciumschicht 1 liegt bevorzugt zwischen etwa 3 und etwa 4 µm.

Die erfindungsgemäßen Masken können entweder - wovon oben ausgegangen wurde - die Größe eines üblichen Halbleiterplättchens haben und durch die Siliciumrippen zwischen den wannenförmigen Vertiefungen 4 in Maskenausschnitte unterteilt sein, deren laterale Abmessungen beispielsweise auf die Größe eines üblichen Halbleiterchips abgestimmt ist, oder die Maske umfaßt nur die durch eine oder zwei wannenförmige Vertiefungen 4 definierte Fläche, d.h. hat nur die laterale Abmessung von beispielsweise 1 oder 2 Halbleiterchips.

Bei der in der Fig. 1A gezeigten Maske ist das Siliciumgerüst mit einer Tantalschicht eingehüllt, welche die der Ionenstrahlung ausgesetzte Oberfläche, die Wände der Löcher und die das Gitter von Siliciumrippen aufweisende Oberfläche bedeckt. Tantal ist ein mechanisch widerstandsfähiges Material, welches von Ionenstrahlen wenig angegriffen wird. Es ist aufgrund seines metallischen Charakters gut elektrisch und thermisch leitfähig und hat außerdem eine Ionenabsorptionsfähigkeit, welche derjenigen des Goldes nur wenig nachsteht. Die Dicke der Tantalschicht 5 liegt auf der den Ionenstrahlen ausgesetzten Seite der Maske (im folgenden Oberseite genannt) in Abhängigkeit von der angewandten Ionenenergie, welche im Bereich zwischen ungefähr 50 und etwa 200 keV liegt, zwischen etwa 0,3 und 0,8 µm. Die Schichtdicke an den Lochwänden ist je nach der Art des Aufbringens um einen Faktor zwischen etwa 1,5 und etwa 3 kleiner als an der Maskenoberseite, und die Schichtdicke auf der das Gitter aus Siliciumrippen aufweisenden Oberfläche der Maske (im folgenden Unterseite genannt) ist größenordnungsmäßig ungefähr gleich dick wie die Schicht auf der Maskenoberseite. Da jedoch die Tantalschicht auf der Maskenunterseite in erster Linie die durch die Schicht auf der Maskenoberseite erzeugten mechanischen Spannungen kompensieren soll, und da diese Spannungen auch noch von der Geometrie der Maske abhängen, läßt sich die notwendige Dicke der Schicht auf der Maskenunterseite nur durch - allerdings einfach durchführbare - Experimente genau bestimmen. Außer der Spannungskompensation dient die Schicht auf der Maskenunterseite auch noch der Wärmeableitung. Außer aus Tantal kann die Schicht 5 auch noch aus Wolfram bestehen, welches sogar noch eine bessere Ionenabsorptionsfähigkeit als das Tantal aufweist (die Wolframschicht auf der Maskenoberseite ist bevorzugt zwischen ungefähr 0,2 und 0,6 µm dick). Es wird bevorzugt, daß - wie in der anhand der Fig. 1A beschriebenen Ausführungsform - die Schicht auf der Maskenoberseite aus demselben Material besteht wie die Schicht auf der Maskenunterseite, jedoch sei klargestellt, daß die Schicht auf der Maskenunterseite, bei der es ja nicht auf eine gute Ionenabsorptionsfähigkeit und auch nicht auf eine gute mechanische Stabilität, sondern neben einer Neigung zum Aufbau von mechanischen Spannungen, allenfalls auf die thermische Leitfähigkeit ankommt, auch aus einem anderen Material als aus dem Schichtmaterial auf der Maskenoberseite bestehen kann.

Die in der Fig. 1B gezeigte Ausführungsform der erfindungsgemäßen Maske unterscheidet sich dadurch von der in der Fig. 1A gezeigten, daß bei ihr das Siliciumgerüst nicht nur mit einer, sondern mit zwei Schichten eingehüllt ist, und zwar mit einer unteren Schicht 6 aus Gold und einer oberen Schicht 7 aus Molybdän. Molybdän ist gegenüber dem Angriff von Ionenstrahlen recht beständig und thermisch und elektrisch leitfähig, aber kein sehr guter Ionenabsorber. Gold hingegen ist gegenüber der Ionenstrahlung nicht sehr widerstandsfähig, dafür aber ein sehr guter Ionenabsorber. Die Schichtdicken auf der Maskenoberseite liegen - wiederum in Abhängigkeit von der Ionenenergie - für Gold zwischen etwa 0,15 und etwa 0,45 µm und für Molybdän zwischen 0,1 und etwa 0,3 µm. In den Löchern 3 der Schicht 1 sind die Schichtdicken - wiederum in Abhängigkeit von der Art der Aufbringung - um einen Faktor im Bereich zwischen etwa 1,5 und etwa 3 kleiner als auf der Maskenoberseite und auf der Maskenunterseite sind die Schichtdicken größenordnungsmäßig gleich wie auf der Maskenoberseite. Die Beschichtung auf der Maskenunterseite ist notwendig zur Kompensation des in der Molybdän/Gold-Schichtstruktur beobachteten Bimetalleffekts und günstig wegen ihrer thermischen Leitfähigkeit.

In der Fig. 1C ist eine Ausführungsform der erfindungsgemäßen Maske gezeigt, bei welcher nur die Oberseite der Schicht 1 und die Wände der Löcher in dieser Schicht mit einer Beschichtung versehen sind. Die Beschichtung besteht aus einer unteren Schicht 6 aus Gold und einer oberen Schicht 8 aus Kohlenstoff. Kohlenstoff läßt zwar Ionen praktisch ungeschwächt hindurch, hat also eine sehr geringe Absorptionsfähigkeit, es ist jedoch außerordentlich mechanisch beständig (die Ionenätzbeständigkeit von Kohlenstoff ist vier bis fünfmal größer als die von Tantal), und es kommt hinzu, daß - wie festgestellt wurde - bereits eine sehr dünne Kohlenstoffschicht in der Lage ist, die Abtragung von Gold mittels Ionenstrahlen zuverlässig zu verhindern. Die Goldschicht auf der Oberseite der Maske ist abhängig von der angewandten Ionenstrahlenergie, zwischen etwa 0,2 und etwa 0,6 µm und die Kohlenstoffschicht 8 größenordnungsmäßig 0,1 µm dick. Die Dicke der Schichten auf den Lochwänden der Schicht 1 sind - wiederum abhängig von der angewandten Aufbringmethode - um einen Faktor zwischen etwa 1,5 und etwa 3 dünner als die Schichten auf der Oberseite der Maske. Der Kohlenstoff muß das Gold so vollständig bedecken, daß Ionen, welche zu der Goldschicht 6 gelangen, in jedem Fall zuerst die Kohlenstoffschicht 8 durchdringen müssen. Da eine Goldschicht der genannten Dicke und auch der Kohlenstoff keine mechanischen Spannungen verursachen und bei der Kombination der beiden Materialien auch kein Bimetalleffekt auftritt, erübrigt sich eine Beschichtung der Maskenunterseite.

Trotzdem ist es vorteilhaft, auch die Unterseite der in der Fig. 1C gezeigten Maske mit einer bevorzugt aus Gold bestehenden Beschichtung zu versehen, weil dadurch die Fähigkeit der Maske, Wärme abzuführen, verbessert wird und deshalb die Aufheizung der Maske noch geringer gehalten werden kann. Eine solche Ausführungsform der erfindungsgemäßen Maske ist in der Fig. 1D gezeigt, in welcher die Goldschicht 6 sich auch über die Unterseite der Schicht 1 und über die Siliciumrippen erstreckt.

Die in der Fig. 1E gezeigte Maske unterscheidet sich dadurch von der in der Fig. 1D gezeigten, daß bei ihr zwischen der Goldschicht 6 und dem Siliciumgerüst eine bevorzugt aus Siliciumnitrid bestehende Schicht 9 aufgebracht ist. Die Schicht 9 ist zwischen etwa 0,1 und etwa 0,2 µm dick. Sie hat den Zweck, in der Goldschicht 6 absorbierte Ionen bzw. Atome oder auch Goldatome an der Diffusion in die P+-dotierte Siliciumschicht 1 zu hindern. Die Gefahr, daß eine solche Diffusion stattfindet, ist insbesondere dann gegeben, wenn die Maske schon über längere Zeit bei Ionenimplantation bzw. Ionenstrahllithographieschritten eingesetzt worden ist. Die im Wege der Diffusion in die Siliciumschicht 1 eingedrungenen Atome oder Ionen wirken sich ähnlich schädlich auf die Stabilität der Siliciumschicht aus, wie direkt in die Siliciumschicht implantierte Ionen. Die Aufbringung einer solchen Diffusionsbarriere ist auch dann empfehlenswert, wenn die Absorberschicht nicht aus Gold, sondern aus einem anderen Material besteht. Für den Fall, daß kein Schichtmaterial gefunden wird, welches für eine bestimmte Ionenart als Diffusionsbarriere dienen könnte, kann man auch so vorgehen, daß man von einer Maske nach längerer Benutzung die dann stark "dotierte" Beschichtung ablöst und anschließend das Siliciumgerüst neu beschichtet. Auf diese Weise läßt sich der wertvollste Teil der Maske, nämlich das Siliciumgerüst, weiterverwenden.

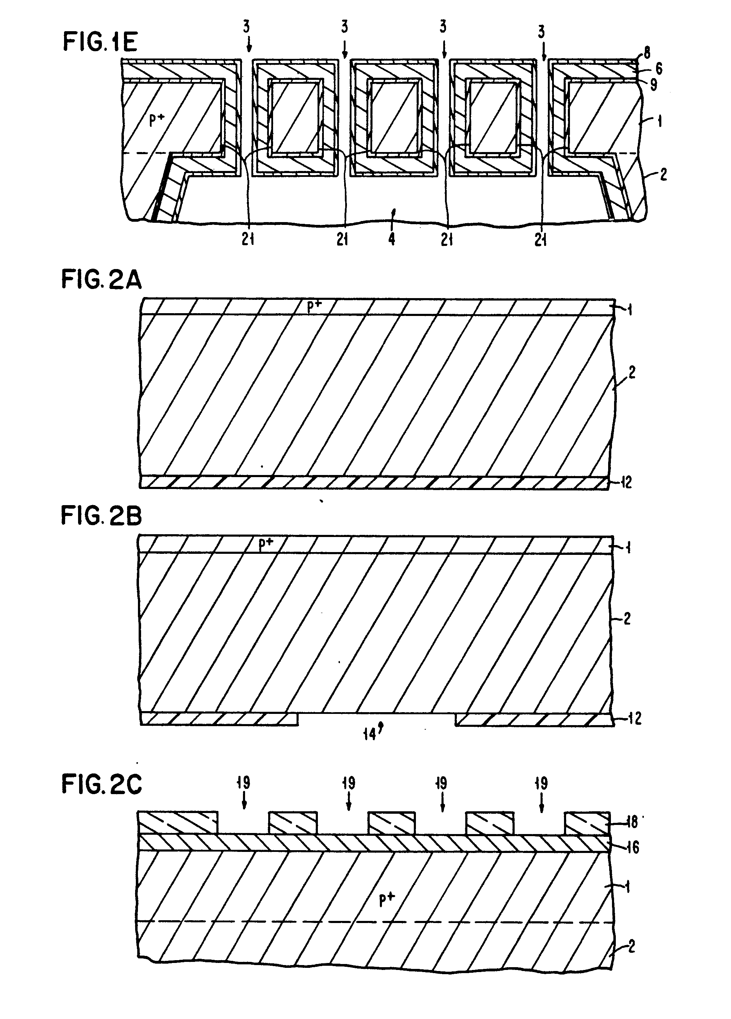

Im folgenden soll anhand der Fign. 2A bis 2H die Herstellung der in der Fig. 1C schematisch dargestellten Maske beschrieben werden.

Als Substrat 2 wird ein N-dotiertes, einkristallines Siliciumplättchen mit (100)-Orientierung verwendet, welches typischerweise eine Dicke von ungefähr 400 µm hat, aber auch zwischen ungefähr 100 und ungefähr 400 µm dick sein kann. Die eine Substratoberfläche (im folgenden Unterseite genannt) wird mit einer 0,5 bis 1 µm dicken Silicumdioxidschicht 12 versehen. Dazu wird das Substrat 2 beispielsweise thermisch oxidiert, indem es eine festgelegte Zeitlang bei einer Temperatur von ungefähr 1000°C einer Sauerstoff/Wasserdampfatmosphäre ausgesetzt wird und nach dem Abkühlen die auf der von der Unterseite abgewandten Oberfläche (im folgenden Oberseite genannt) aufgewachsene Oxidschicht abgelöst wird.

Anschließend wird das Substrat 2 von der Oberseite her mit einer eine P+-Leitfähigkeit vermittelnden Verunreinigung hochdotiert. Es ist günstig, als Verunreinigung Bor zu verwenden. Zur Dotierung werden entweder in bekannter Weise Ionen der Verunreinigung implantiert oder wird die Verunreinigung eindiffundiert, wobei die Diffusion bei hohen Temperaturen entweder in einer evakuierten Kapsel unter Verwendung von bordotiertem Silicium als Diffusionsquelle oder im offenen Rohr vorgenommen wird, wobei ein Trägergasstrom, welcher als Borquelle bevorzugt $BBr_3$ enthält, über die Halbleiterplättchen strömt. Bei der Dotierung entsteht die P+-dotierte Siliciumschicht 1, in welcher die Dotierung - sofern mittels Diffusion dotiert wird - an der Oberfläche am größten ist und deren Dotierung mit dem Abstand zur Oberfläche abnimmt und deren Dicke als der Abstand von der Oberfläche definiert ist, bei dem die Dotierungskonzentration $7 \times 10^{19}$ Verunreinigungsatome/cm³ ist. Die dann vorliegende Struktur zeigt im Querschnitt die Fig. 2A. Grundsätzlich kann die Schicht 1 auch eine auf das Substrat 2 aufgebrachte Epitaxieschicht sein.

Mittels eines photolithographischen Ätzverfahrens wird bzw. werden nun eine Öffnung bzw. Öffnungen 14 in der Oxidschicht 12 auf der Plattenunterseite erzeugt (siehe Fig. 2B). Die lateralen Abmessungen der Öffnungen bzw. der Öffnungen 14 sind bestimmt durch die lateralen Abmessungen der in einem späteren Verfahrensschritt zu ätzenden wannenförmigen Vertiefungen.

Um die bei den folgenden Verfahrensschritten interessierenden Details besser zu illustrieren, zeigen die Fign. 2C bis 2H - anders als die Fign. 2A und 2B, welche Querschnitte durch die gesamte Dicke des Halbleiterplättchens darstellen - vergrößerte Ausschnitte aus den oberseitigen Oberflächenbereichen der herzustellenden Maskenstruktur. Auf die Plättchenoberseite wird nun eine ungefähr 0,8 μm dicke Siliciumdioxidschicht 16 thermisch oder bevorzugt bei einer Temperatur von kleiner gleich ungefähr 600°C mittels chemischen Niederschlagens aus der Dampfphase oder auch mittels Kathodenzerstäubens aufgewachsen. Auf der Siliciumdioxidschicht 16 wird eine ungefähr 0,5 bis ungefähr 1 μm dicke Schicht 18 aus einem strahlungsempfindlichen Lack durch Aufschleudern aufgebracht. Der strahlungsempfindliche Lack muß, da ein sehr hoch aufgelöstes Maskenmuster erzeugt werden soll, elektronenstrahl-, ionenstrahl-, oder röntgenstrahlempfindlich sein.

Beispielsweise mittels eines Elektronenstrahl-Muster-Erzeugers wird nun die Lackschicht 18 selektiv entsprechend dem gewünschten Maskenmuster bestrahlt. Anschließend wird entwickelt, wobei von der Lackschicht 18 ein Muster übrigbleibt, welches genau dem Muster entspricht, welches in einem späteren Verfahrensschritt in die Siliciumschicht 1 geätzt werden soll und welches etwas größere Öffnungen aufweist als das gewünschte Maskenmuster. Mit den besten, heute kommerziell erhältlichen Elektronenstrahl-Muster-Erzeugern ist man bei einer Lackschichtdicke zwischen ungefähr 0,5 und ungefähr 1 μm in der Lage, Linien mit einer Breite von ⩽ 1 μm mit höchster Präzision in die Lackschicht zu übertragen. Nach dem Entwickeln liegt eine Struktur vor, wie sie die Fig. 2C im Querschnitt zeigt.

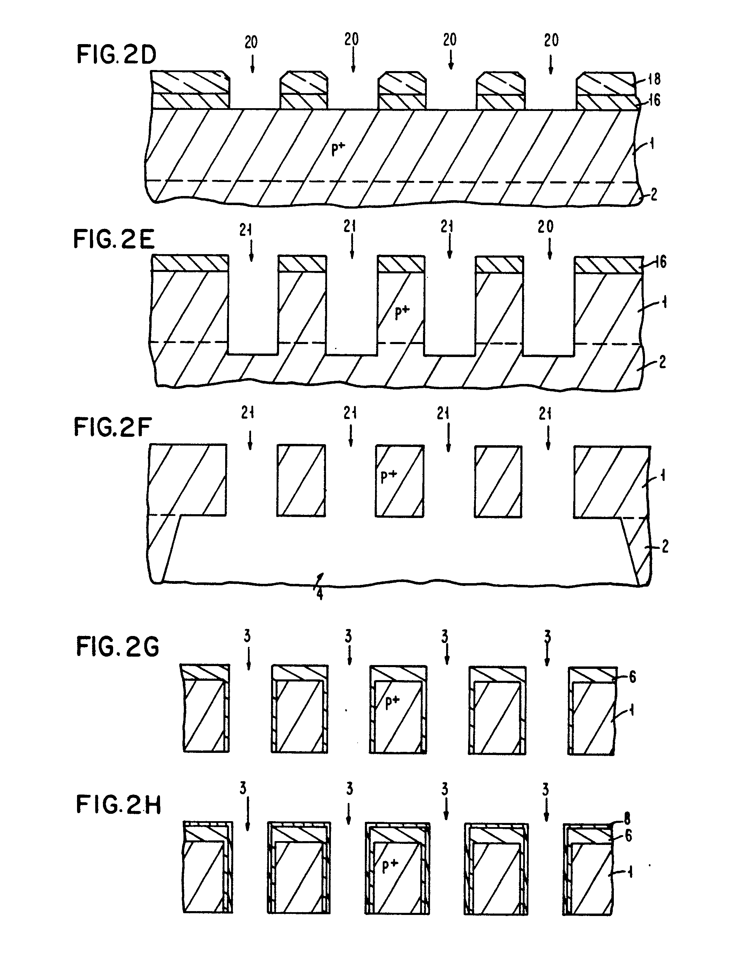

Im folgenden Verfahrensschritt wird mittels reaktiven Ionenätzens in einer $CHF_3$ oder ein $CF_4/H_2$-Gemisch enthaltenden Atmosphäre die $SiO_2$-Schicht 16 unter Verwendung der Lackmaske 18 selektiv, d. h. dort, wo sich in der Lackschicht 18 die Öffnungen 19 befinden, weggeätzt. Zum reaktiven Ionenätzen wird ein planares Kathodensystem verwendet, in dem ein Druck von ca. 53 μbar herrscht. Die HF-Leistung liegt bei ca. 0,2 Watt/cm² und bei Verwendung von $CF_4$ und $H_2$ liegt das Flußratenverhältnis $CF_4$:$H_2$ bei ungefähr 3,5:1. Dabei kann das in der Lackschicht ausgebildete Muster mit hoher Maßtreue auch dann in eine - wie die vorliegende - relativ dicke $SiO_2$-Schicht geätzt werden, wenn das Muster Linienbreiten ⩽ 1 μm aufweist. Bei dem reaktiven Ionenätzen wird die Lackschicht 18 zu einem geringen Teil abgebaut. Die Öffnungen in der Siliciumdioxidschicht 16 haben zur Substratoberfläche senkrechte Wände und fluchten genau mit den Öffnungen in der Lackschicht 18. Die dann vorliegende Struktur zeigt die Fig. 2D im Querschnitt, in welcher die in den Lack und in das Siliciumdioxid geätzten Öffnungen nun mit der Nummer 20 bezeichnet sind.

Im folgenden Verfahrensschritt wird die P+-dotierte Siliciumschicht 1 selektiv geätzt. Dabei wird ein reaktives Ionenätzverfahren angewandt, bei dem in einer Argon und Chlor enthaltenden Atmosphäre gearbeitet wird. Die Struktur in der ungefähr 0,8 μm dicken $SiO_2$-Schicht 16 dient dabei als Ätzmaske. Die Bedingungen beim Ätzen können ohne weiteres so gewählt werden, daß ein Ätzgeschwindigkeitenverhältnis zwischen $SiO_2$ und Si von 1:10 erreicht werden kann. Wird bei dem Verfahren mit einem planaren Kathodensystem bei einem Druck von ca. 1,33 x $10^{-2}$ mbar in einer Atmosphäre, welche 97 Vol.% Argon und 3 Vol.% Chlor enthält, gearbeitet, so werden in die P+-dotierte Siliciumschicht 1 Löcher mit zur Substratoberfläche senkrechten Wänden geätzt. Eine Unterätzung ist nicht feststellbar. Beim Ätzen der Schicht 1 wird auch die $SiO_2$-Schicht 16 allmählich abgetragen ($SiO_2$-Reste, die dann noch vorhanden sind, werden am besten durch Eintauchen in gepufferte Flußsäure entfernt). Nach dem Ätzen der Schicht 1 liegt die in der Fig. 2E im Querschnitt gezeigte Struktur vor, in der die Löcher in der Schicht 1 mit der Nummer 21 bezeichnet sind. Die Tiefe, bis zu der in das Silicium hineingeätzt wird, ist völlig unkritisch, solange sie größer ist als die definierte Dicke der P+-dotierten Siliciumschicht 1.

Nach dem Erzeugen der Löcher 21 in der Schicht 1 erfolgt das Ätzen der wannenförmigen Vertiefungen 4 von der Plättchenrückseite her, wobei die Siliciumdioxidschicht 12 mit den Öffnungen 14 als Ätzmaske dient.

Zum Ätzen wird eine aus Äthylendiamin, Brenzkatechin, Wasser und u.U. Wasserstoffperoxid bestehende Lösung bei einer Temperatur von ⩽ 118°C verwendet. Diese Lösung hat die Eigenschaft, daß sie einkristallines Silicium, welches N- bzw. nicht P+-dotiert ist, anisotrop (100-Ebenen werden ca. 16mal schneller als 111-Ebenen geätzt) und P+-dotiertes Silicium außerordentlich wenig ätzt. Bevorzugt besteht die Lösung aus 72 g Brenzkatechin, 630 ml Äthylendiamin, 115 ml Wasser und 29 ml $H_2O_2$. Die Steuerung des Ätzens der wannenförmigen Vertiefungen 4 ist aufgrund der genannten Eigenschaften der Ätzlösung sehr einfach; genau genommen wird die Ätzung durch die Bedingungen, unter welchen die Dotierung der Schicht 1 erfolgt ist, bestimmt. Der Ätzvorgang senkrecht zur Plättchenoberfläche kommt nämlich weitgehend zum Stillstand, wenn die Ätzlösung von der Rückseite her alles Silicium weggeätzt hat, dessen Borkonzentration < 7 x $10^{19}$ Atome/cm³ ist. D. h., es bleibt eine Siliciumschicht stehen, deren Borkonzentration ⩾ 7 x $10^{19}$ Atomen/cm³ ist, und dies ist definitionsgemäß die Schicht 1. Nach dem Ätzen der wannenförmigen Vertiefungen 4 liegt die in der Fig. 2F gezeigte Struktur vor.

Im nächsten Verfahrensschritt wird auf die Oberseite der Maske eine Goldschicht aufgebracht. Das Aufbringen kann entweder mittels Aufdampfens in der üblichen Art und Weise oder mittels Kathodenzerstäubens erfolgen. In der Kathodenzerstäubungsapparatur liegt die Maske auf einer Platte, welcher in paralleler Anordnung eine Auftreffplatte gegenüberliegt, welche aus Gold besteht oder eine Auflage aus Gold besitzt. Der Abstand zwischen der Maske und der Auftreffplatte beträg ungefähr 3 cm, das Kathodenzerstäuben wird in einer Argon enthaltenden Atmosphäre durchgeführt, wobei ein Druck von ungefähr 1,33 x 10$^{-1}$mbar herrscht. Je nach den Ionenenergien, welchen die Maske ausgesetzt werden soll, und welche zwischen ungefähr 50 und 200 keV liegen, wird eine Goldschicht aufgebracht, deren Dicke zwischen ungefähr 0,2 und 0,6 µm beträgt. Das Gold scheidet sich nicht nur auf der oberen Oberfläche der Schicht 1 ab, sondern auch an den Wänden der Löcher 21. Bei den angegebenen Kathodenzerstäubungsbedingungen liegt das Verhältnis der Dicke der auf der Oberfläche der Schicht 1 aufgebrachten Goldschicht zur Dicke der an den Wänden der Löcher 21 abgeschiedenen Golds bei ungefähr 3 : 1. Die Haftung des Goldes auf dem Silicium ist ausreichend, solange die Maske keinem Naßprozeß unterworfen wird. Die nach dem Aufbringen der Goldschicht 6 vorliegende Struktur ist in der Fig. 2G im Querschnitt dargestellt. Schließlich wird auf der Goldschicht 6 eine Kohlenstoffschicht aufgebracht. Die Kohlenstoffschicht wird entweder aus einer Bogenentladung heraus, bei welcher Kohleelektroden verwendet werden, aufgedampft, oder mittels Kathodenzerstäubens aufgebracht, wobei eine Auftreffplatte aus Kohlenstoff verwendet wird und sonst unter gleichen Bedingungen wie beim Aufbringen der Goldschicht gearbeitet wird. Die Kohlenstoffschicht auf der Oberseite der Maske wird größenordnungsmäßig 0,1 µm dick gemacht. Diese Dicke ist größer als zum Schutz der Goldschicht notwendig, bei dieser Schichtdicke ist aber sichergestellt, daß auch das Gold an den Wänden der Löcher 21 bzw. im Bereich der Lochkanten mit einer ausreichend dicken Kohlenstoffschicht bedeckt ist. Die nach dem Aufbringen der Kohlenstoffschicht 8 vorliegende Struktur zeigt die Fig. 2H, welche einen Ausschnitt aus der Fig. 1C darstellt. Die lateralen Abmessungen der Löcher 3 in dieser Struktur müssen mit den lateralen Abmessungen des gewünschten Maskenmusters übereinstimmen. Die lateralen Abmessungen der Öffnungen 19 in der strahlungsempfindlichen Schicht 18, welche am Anfang des Herstellungsprozesses erzeugt worden sind, müssen deshalb unter Berücksichtigung der Dicken der an den Wänden der Löcher 21 abgeschiedenen Schichtten aus Gold und Kohlenstoff dimensioniert werden.

Um die in der Fig. 1D im Querschnitt gezeigte Ausführungsform der erfindungsgemäßen Maske herzustellen, muß das oben beschriebene Herstellungsverfahren nur dahingehend verändert werden, daß vor dem Aufbringen der Kohlenstoffschicht 8 auch noch auf der Unterseite des Siliciumgerüsts eine Goldschicht aufgebracht wird. Die Dicke der Maske auf der Unterseite ist unkritisch, sie wird jedoch bevorzugt ungefähr gleich dick wie die Goldschicht auf der Oberseite gemacht. Bei der Herstellung dieser Ausführungsform der erfindungsgemäßen Maske ist bei der Dimensionierung der Löcher in der strahlungsempfindlichen Schicht zu berücksichtigen, daß durch das Aufbringen der Goldschicht auf der Maskenunterseite die Dicke der Goldschicht an den Wänden der Löcher 21 weiter verstärkt wird.

Zur Herstellung der in der Fig. 1A im Querschnitt gezeigten Ausführungsform der erfindungsgemäßen Maske wird ausgehend von der in der Fig. 2F gezeigten Struktur ein Tantalüberzug durch beidseitiges Aufbringen einer Tantalschicht erzeugt. Das Aufbringen des Tantals kann in bekannter Weise mittels Aufdampfens oder mittels Kathodenzerstäubens erfolgen. Die Tantalschicht auf der Maskenoberseite wird je nach der Energie der Ionen, welcher die Maske ausgesetzt werden soll (die Energie liegt zwischen ungefähr 50 und etwa 200 keV), zwischen etwa 0,3 und etwa 0,8 µm dick gemacht. Die Schicht auf der Maskenunterseite wird ungefähr gleich dick gemacht, jedoch ist es zur Festlegung der genauen Dicke notwendig, Versuche durchzuführen, wobei das entscheidende Kriterium für die Dicke der Schicht auf der Maskenunterseite die vollständige Kompensation der thermisch bedingten mechanischen Spannung ist. Beim Aufbringen der Tantalschicht 5 auf der Ober- und der Unterseite des Siliciumgerüsts wird auch Tantal auf den Wänden der Löcher 21 abgeschieden. Es kann leicht erreicht werden, daß die Dicke der Tantalschicht auf den Lochwänden geringer ist als die Schichtdicke auf der Ober- und der Unterseite der Maske. Statt einer Tantalschicht kann auch eine Schicht aus Wolfram beidseitig auf der Maske aufgebracht werden. Die Wolframschicht wird auf der Maskenoberseite zwischen ungefähr 0,2 und 0,6 µm dick gemacht. Bezüglich der Dicke der Schicht auf der Unterseite und an den Wänden der Löcher 21 gilt das für das Tantal gesagte entsprechend.

Um die in der Fig. 1B im Querschnitt gezeigte Ausführungsform der erfindungsgemäßen Maske herzustellen, wird bis auf den letzten Verfahrensschritt dasselbe Verfahren wie bei der Herstellung der in der Fig. 1D gezeigten Ausführungsform der Maske angewandt. Es folgt dann statt dem einseitigen Aufbringen einer Kohlenstoffschicht das beidseitige Aufbringen einer Molybdänschicht 7. Das Aufbringen der Molybdänschicht 7 wird in zwei aufeinanderfolgenden identischen Verfahrensschritten mittels Aufdampfens oder Kathodenzerstäubens durchgeführt. Die Molybdänschicht auf der Oberseite der Maske muß, da Molybdän - wie auch Tantal, Wolfram und Titan - um den Faktor 3 bis 4 weniger widerstandsfähig gegenüber Ionen als Kohlenstoff ist, etwas dicker als die Kohlenstoffschicht, d.h. zwischen etwa 0,2 und 0,3 µm dick gemacht werden. Bezüglich der Dicke der Molybdänschicht auf der Unterseite der Maske und auf den Wänden der Löcher gilt das bei Tantal gesagte entsprechend. Bei dieser Ausführungsform der erfindungsgemäßen Maske kann als Schicht 6 statt Gold auch Platin, Wolfram, Tantal und mit Einschränkung Silber, welches allerdings eine wesentlich geringere Absorptionsfähigkeit als Gold hat, und als Schicht 7 statt Molybdän auch Titan, Wolfram oder Tantal verwendet werden. Die dabei notwendigen Dicken müssen durch einfache, im Rahmen des fachmännischen Handelns liegende Experimente ermittelt werden, wobei als Kriterien für die richtige Dicke die vollständige Absorption der Ionen in der Beschichtung der Maskenoberseite, die gute mechanische Widerstandsfähigkeit gegenüber Ionen, die vollständige Kompensation der mechanischen Spannungen und zu einem gewissen Grad die elektrische und thermische Leitfähigkeit sind. Zur Herstellung einer Ausführungsform der erfindungsgemäßen Maske mit Diffusionsbarriere, wie sie z. B. in der Fig. 1E im Querschnitt dargestellt ist, wird wie bei dem oben beschriebenen Herstellungsverfahren vorgegangen, bis die in der Fig. 2F gezeigte Struktur erzeugt ist. Anschließend wird vor dem Aufbringen der ionenabsorbierenden Schicht ein- oder zweiseitig eine $Si_3N_4$-Schicht 9 durch chemisches Niederschlagen aus der Dampfphase im Plasma unter Verwendung eines Gemisches aus Ammoniak und einer Siliciumverbindung, wie z. B. $SiH_4$, bei Temperaturen unterhalb 600°C hergestellt. Die Schicht 9 wird zwischen etwa 0,1 und etwa 0,2 µm dick gemacht.

Die erfindungsgemäßen Masken lassen sich immer dann verwenden, wenn Halbleiterbereiche mittels Ionenimplantation dotiert oder auf "photo"-lithographischem Weg Strukturen in strahlungsempfindlichen Lacken erzeugt werden sollen. Solche Lackstrukturen werden beispielsweise bei der Herstellung von mikrominiaturisierten Schaltungen in Halbleiterplättchen und bei der Herstellung von magnetischen Zylinderdomänen-Speicherbauteilen als Ätzmaske und als Abhebe(lift-off)-Masken verwendet. Mit den erfindungsgemäßen Masken lassen sich Muster in strahlungsempfindliche Lackschichten übertragen, welche Musterelemente mit Breite <1 µm aufweisen. Die Übertragung solcher Muster ist zwar auch mit Geräten möglich, welche mit einem fokussierten Strahl arbeiten, dessen Durchmesser kleiner ist als die Dimension des kleinsten zu übertragenden Musterelements, und welcher computergesteuert über das zu bestrahlende Substrat geführt wird, jedoch kann man diesen bekannten Geräten nicht mit einem so hohen Durchsatz arbeiten, wie er für eine Massenfertigung erforderlich ist. Die erfindungsgemäßen Masken haben außer dem Vorteil, daß sie Muster mit höchster Präzision übertragen können, den weiteren Vorteil, daß sich mit ihnen ein hoher Durchsatz erzielen läßt. Dies ist deshalb möglich, weil die erfindungsgemäße Maske mit ungewöhnlich hohen Ionenströmen bestrahlt werden kann, ohne daß dabei eine untolerierbar starke Verzerrung der Masken eintritt. Hohe Ionenströme führen also nicht dazu, daß die zu übertragenden Muster verzerrt sind, aber sie gewähren einen hohen Durchsatz.

Bei der Anwendung zeigt die Maske mit ihrer Unterseite in Richtung auf das zu bestrahlende Substrat. Der Abstand zwischen der Maske und dem Substrat liegt in der Größenordnung von 1/2 mm. Die Maske wird zu dem mit dem strahlungsempfindlichen Lack beschichteten, zu bearbeitenden Werkstück, beispielsweise einem Halbleiterplättchen, ausgerichtet. Anschließend wird mit einem Ionenstrahl mit einem bevorzugten Durchmesser von ca. 1mm die Maske Zeile für Zeile überstrichen, bis jeder Punkt der Maske sich im Strahlengang befunden hat. Bei der Ionenimplantation wird die Maske je nach dem Leitungstyp, welcher erzeugt werden soll, bevorzugt mit Bor-, Phosphor- und Arsenionen bestrahlt, und bei der Ionenstrahllithographie werden bevorzugt Wasserstoff-, Lithium- und Arsenionen eingesetzt. Bei der Ionenimplantation liegt die bevorzugte Ionenenergie zwischen etwa 120 und 200 keV und die Dosis bei größenordnungsmäßig $10^{15}$ Ionen/$cm^2$. Bei der Ionenstrahllithographie liegt die Ionenenergie bevorzugt zwischen 50 und 200 keV und die Dosis größenordnungsmäßig bei $10^{12}$ bis $10^{13}$ Ionen/$cm^2$. Die Dauer der Bestrahlung liegt für eine 5 x 5 mm große Fläche, was etwa der Größe eines typischen Halbleitertyps entspricht, üblicherweise zwischen etwa 50 und etwa 200 Millisekunden.

Es ist einleuchtend, daß es mit der erfindungsgemäßen Maske, welche ja durchgehende Löcher aufweist, nicht möglich ist, ringförmige bzw. in sich geschlossene Musterelemente zu übertragen. Dieser Schwierigkeit kann dadurch begegnet werden, daß zwei Masken verwendet werden, welche in der Weise sich ergänzende Teile des ringförmigen Musterelementes enthalten, daß wenn die Lackschicht durch beide Masken bestrahlt wird, das ringförmige Musterelement latent entsteht. Einzelheiten dieses Verfahrens und der dabei verwendeten Masken sind in der DE-OS 27 39 502 beschrieben.

Die Ionenstrahlmaske erwärmt sich, wenn sie mit einer ausreichend wärmeleitfähigen Beschichtung versehen ist, auf maximal etwa 150°C. Bei dieser Temperatur können bereits mechanische Spannungen auftreten, welche, wenn sie nicht kompensiert werden, zu einer nicht tolerierbaren Deformation der Maske führen. Die mit hoher Energie auf die Maskenoberfläche auftreffenden Ionen attakkieren das Maskenmaterial und tragen umso mehr Material ab, je weniger mechanisch widerstandsfähig das Material an der den Ionen ausgesetzten Maskenoberfläche ist. Von der Abtragung bedroht ist weniger das Material auf der Oberfläche der Maskenoberseite, sondern vielmehr das Material an den Kanten, d.h. dort, wo die obere Oberfläche der Maske in die Löcher übergeht. Dies ist darauf zurückzuführen, daß die Abtragungsgeschwindigkeit mit zunehmendem Auftreffwinkel der Ionen bis zu einem Winkel von 60° ansteigt und erst dann wieder abfällt. Hat also die Abtragung an der Kante unter Bildung eines von Null verschiedenen Auftreffwinkels begonnen, dann steigt die Abtragungsgeschwindigkeit stark an. Die Folge ist eine Abrundung der Kanten (Ausbildung einer Phase). Eine solche Abtragung und damit eine Bildung runder Kanten wird erfindungsgemäß dadurch verhindert, daß die den Ionen ausgesetzte Oberfläche der Maske aus einem besonders mechanisch widerstandsfähigen Material, wie z. B. Kohlenstoff, besteht.

**Patentansprüche**

1. Schattenwurfmaske, welche eine dunne P+-dotierte Siliciumschicht (1) mit durchgehenden, dem Maskenmuster angepaßten Löchern und ein diese Schicht (1) in Bereichen, wo sich keine Löcher befinden, unterstützendes Gitter (2) aus anders als die Siliciumschicht (1) dotierten Siliciumrippen enthält, welche mindestens auf ihrer von dem Gitter (2) abgewandten Seite (im folgenden Oberseite genannt) eine Ionen absorbierende Schicht aufweist und bei welcher mindestens die der Ionenstrahlung ausgesetzte Oberfläche elektrisch und thermisch leitfähig ist, dadurch gekennzeichnet, daß die Beschichtung des Siliciumgerüsts (1, 2) der Maske, dort, wo sie den Ionenstrahlen ausgesetzt werden soll, entweder aus einem zugleich gegenüber dem mechanischen Angriff der Ionen resistenten und Ionen absorbierenden Material oder aus einer Doppelschicht besteht, bei der die der Ionenstrahlung zugewandte Schicht aus einem gegenüber dem mechanischen Angriff der Ionen resistenten Material und die dem Siliciumgerüst zugewandte Schicht aus einem Ionen absorbierenden Material besteht, wobei die Beschichtung unter Berücksichtigung der Ionenenergie und der Ionenabsorptionsfähigkeit so dick gemacht wird, daß keine Ionen in das Silicium eindringen und daß die das Gitter (2) aufweisende Seite der Maske (im folgenden Unterseite genannt) eine - bevorzugt mit der auf der Oberseite aufgebrachten identische -, die durch die Beschichtung der Oberseite aufgebaute mechanische Spannung kompensierende Beschichtung aufweist.

2. Schattenwurfmaske nach Anspruch 1, dadurch gekennzeichnet, daß die P+-Siliciumschicht (1) vor dem Eindringen von Ionen bzw. Atomen aus dem absorbierenden Material mindestens einseitig durch eine Diffusionsbarriere (9) geschützt ist.

3. Schattenwurfmaske nach Anspruch 1 oder 2, dadurch gekennzeichnet, daß als absorbierendes Material ein Material aus der Gruppe Gold, Silber, Wolfram, Platin und Tantal, als ionenresistentes Material ein Material aus der Gruppe Kohlenstoff, Molybdän, Wolfram, Tantal und Titan und als Material für die Diffusionsbarriere (9) $Si_3N_4$ eingesetzt sind.

4. Schattenwurfmaske nach Anspruch 3, dadurch gekennzeichnet, daß die aus nur einem Material gebildete Beschichtung aus Tantal oder Wolfram besteht.

5. Schattenwurfmaske nach Anspruch 3, dadurch gekennzeichnet, daß auf dem Siliciumgerüst (1, 2) eine Schicht (6) aus Gold und auf der Goldschicht eine Schicht (7) aus Molybdän aufgebracht ist.

6. Schattenwurfmaske, welche eine dünne P+-dotierte Siliciumschicht (1) mit durchgehenden, dem Maskenmuster angepaßten Löchern und ein diese Schicht (1) in Bereichen, wo sich keine Löcher befinden, unterstützendes Gitter (2) aus anders als die Siliciumschicht (1) dotierten Siliciumrippen enthält, welche mindestens auf ihrer von dem Gitter (2) abgewandten Seite (im folgenden Oberseite genannt) eine Ionen absorbierende Schicht aufweist und bei welcher mindestens die der Ionenstrahlung ausgesetzte Oberfläche elektrisch und thermisch leitfähig ist, dadurch gekennzeichnet, daß mindestens auf der Oberseite der Maske das Siliciumgerüst (1, 2) mit einer Schicht (6) aus Gold und einer darüberliegenden Schicht (8) aus Kohlenstoff bedeckt ist.

7. Schattenwurfmaske nach Anspruch 6, dadurch gekennzeichnet, daß, wenn die Maske einer Bestrahlung mit Ionen ausgesetzt werden soll, die mindestens ein Proton enthalten und deren Energie im Bereich zwischen 50 und 200 KeV liegt, auf der Oberseite der Maske die Goldschicht (6) zwischen etwa 0,2 und etwa 0,6 µm und die Kohlenstoffschicht (8) größenordnungsmäßig 0,1 µm dick sind und daß die Dicke der Schichten auf den Wänden der Löcher (21) in der Schicht (1) etwa um den Faktor 3 dünner ist als die Dicke der Schichten auf der Maskenoberseite.

8. Schattenwurfmaske nach Anspruch 6 oder 7, dadurch gekennzeichnet, daß die Beschichtung auf der Oberseite der Maske und auf den Lochwänden aus einer Gold-, einer Kohlenstoffschicht (6 bzw. 8) und gegebenenfalls einer Diffusionsbarriere (9), bevorzugt aus Siliciumnitrid, besteht und die Goldschicht (6) und gegebenenfalls auch die Diffusionsbarriere (9) sich auch noch über die Unterseite der Maske erstrecken.

## Claims

1. Shadow projection mask comprising a thin P+-doped silicon layer (1) with through holes adapted to the mask pattern, and a grid (2) supporting this layer (1) in areas without holes and consisting of silicon ribs doped differently from the silicon layer (1) having on at least its side (in the following called upper side) facing away from the grid (2) an ion-absorbing layer, and where at least the surface exposed to ion radiation is electrically and thermally conductive; characterized in that where it is to be exposed to the ion beams the coating of the silicon frame (1, 2) of the mask consists either of a material that is both resistant to the mechanical attack of the ions and ion-absorbing, or of a double layer where the layer exposed to the ion radiation consists of a material resistant to the mechanical attack of the ions, and the layer facing the silicon frame of an ion-absorbing material with the coating, taking into consideration the ion energy and absorption characteristics being of such a thickness that no ions penetrate into the silicon, and that the mask side comprising the grid (2) (in the following called lower side) having a coating preferably identical with that deposited on the upper side - which compensates the mechanical tension created by the coating of the upper side.

2. Shadow projection mask as claimed in claim 1,
characterized in that
the P+-silicon layer (1) is protected against penetrating ions and atoms from the absorbing material at least on one side by a diffusion barrier (9).

3. Shadow projection mask as claimed in claims 1 or 2,
characterized in that
as the absorbing material a material selected from the group consisting of gold, silver, tungsten, platinum, and tantalum is used, and as the ion-resistant material a material selected from the group consisting of carbon, molybdenum, tungsten, tantalum, and titanium is used, and that as the material for the diffusion barrier (9) $Si_3N_4$ is used.

4. Shadow projection mask as claimed in claim 3,
characterized in that
the coating formed of one material only consists of tantalum or tungsten.

5. Shadow projection mask as claimed in claim 3,
characterized in that
on the silicon frame (1, 2) a layer (6) of gold, and on the gold layer a layer (7) of molybdenum are applied.

6. Shadow projection mask comprising a thin P+-doped silicon layer (1) with through holes adapted to the mask pattern, and a grid (2) supporting this layer (1) in areas without holes and consisting of silicon ribs doped differently from the silicon layer (1) having on at least its side (in the following called upper side) facing away from the grid (2) an ion-absorbing layer, and where at least the surface exposed to ion radiation is electrically and thermally conductive, characterized in that at least on the upper side of the mask the silicon frame (1, 2) is covered with a layer (6) of gold and a superimposed layer (8) of carbon.

7. Shadow projection mask as claimed in claim 6, characterized in that when the mask is to be exposed to an irradiation with ions containing at least a proton and whose energy is between 50 and 200 kev the gold layer (6) on the upper side of the mask is between approximately 0.2 and approximately 0.6 μm thick and the carbon layer (8) is in the order of 0.1 μm thick, and that the thickness of the layers on the walls of the holes (21) in the layer (1) is thinner approximately by a factor of 3 than the thickness of the layers on the upper side of the mask.

8. Shadow projection mask as claimed in claim 6 or 7, characterized in that the coating on the upper side of the mask and on the hole wall consists of a gold layer, a carbon layer (6 and 8) and if necessary of a diffusion barrier (9) preferably of silicon nitride, and that the gold layer (6) and if necessary the diffusion barrier (9) also extend over the lower side of the mask.

## Revendications

1. Masque projetant l'ombre, qui comprend une couche mince de silicium à dopage P+ (1) comportant des trous traversants adaptés à la configuration du masque et un réseau (2) soutenant cette couche (1) là où il n'y a pas de trous, comprenant des nervures de silicium d'un autre dopage que la couche de silicium (1), qui comporte, au moins de son côté opposé au réseau (2) (appelé face supérieure par la suite) une couche absorbant les ions, et dans lequel la surface exposée au rayonnement ionique est électriquement et thermiquement conductrice, caractérisée en ce que le revêtement de la charpente de silicium (1, 2) du masque est constitué, là où il doit être exposé aux rayons d'ions, par une matière à la fois résistance vis-à-vis de l'attaque mécanique des ions et absorbant les ions, ou par une double couche dans laquelle la couche située du côté du rayonnement ionique est constituée par une matière résistant à l'attaque mécanique des ions et la couche située du côté de la charpente de silicium par une matière absorbant les ions, le revêtement ayant, en tenant compte de l'énergie ionique et de la capacité d'absorption des ions, une épaisseur telle qu'il ne pénètre pas d'ions dans le silicium, et en ce que la face du masque comportant le réseau (2) (appelée par la suite face inférieure) comporte un revêtement, de préférence identique à celui appliqué sur la face supérieure, compensant la contrainte mécanique produite par le revêtement de la face supérieure.

2. Masque selon la revendication 1, caractérisé en ce que la couche de silicium P+ (1) est protégée au moins d'un côté par une barrière de diffusion (9) contre la pénétration d'ions ou d'atomes provenant de la matière absorbante.

3. Masque selon la revendication 1 ou 2, caractérisé en ce qu'on utilise, comme matière absorbante, une matière du groupe comprenant l'or, l'argent, le tungstène, le platine et le tantale, comme matière résistant aux ions, une matière du groupe comprenant le carbone, le molybdène, le tungstène, le tantale et le titane et, comme matière pour la barrière de diffusion (9), $Si_3N_4$.

4. Masque selon la revendication 3, caractérisé en ce que le revêtement constitué par une seule matière est en tantale ou en tungstène.

5. Masque selon la revendication 3, caractérisé en ce qu'une couche (6) d'or est appliquée sur la charpente de silicium (1, 2) et une couche (7) de molybdène sur la couche d'or.

6. Masque projetant de l'ombre, qui comprend une couche mince de silicium à dopage P+ (1) comportant des trous traversants adaptés à la configuration du masque et un réseau (2) soutenant cette couche (1) là où il n'y a pas de trous, comprenant des nervures de silicium d'un autre dopage que la couche de silicium (1), qui comporte, au moins de son côté opposé au réseau (2) (appelé face supérieure par la suite) une couche absorbant les ions, et dans lequel la surface exposée au rayonnement ionique est électriquement et thermiquement conductrice, caractérisé en ce qu'au moins sur la face supérieure du masque, la charpente de silicium (1, 2) est recouverte d'une couche (6) d'or et d'une couche (8) de carbone placée au-dessus.

7. Masque selon la revendication 6, caractérisé en ce que, lorsque le masque doit être exposé à une irradiation par des ions qui contiennent au moins un proton et dont l'énergie est comprise entre 50 et 200 KeV, sur la face supérieure du masque, la couche d'or (6) a une épaisseur comprise entre environ 0,2 et environ 0,6 µm et la couche de carbone (8) a une épaisseur de l'ordre de 0,1 µm, et en ce que l'épaisseur des couches situées sur les parois des trous (21) de la couche (1) est inférieure à peu près d'un facteur 3 à l'épaisseur des couches situées sur la face supérieure du masque.

8. Masque selon la revendication 6 ou 7, caractérisé en ce que le revêtement sur la surface supérieure du masque et sur les parois des trous est constitué par une couche d'or, une couche de carbone, respectivement (6) et (8) et éventuellement une barrière de diffusion (9), de préférence en nitrure de silicium, et en ce que la couche d'or (6), ainsi éventuellement que la barrière de diffusion (9) s'étendent aussi en plus sur la face inférieure du masque.

0 078 336

**FIG. 1A**

**FIG. 1B**

**FIG. 1C**

**FIG. 1D**

FIG. 1E

FIG. 2A

FIG. 2B

FIG. 2C

FIG.2D

FIG.2E

FIG.2F

FIG.2G

FIG.2H